# EUROPEAN PATENT APPLICATION

(11) **EP 4 739 067 A1**
(43) Date of publication of application: **06.05.2026**
(21) Application number: 25211963.1
(22) Date of filing: 29.10.2025
(51) Int. Cl.: H10W 46/00, H10W 70/60

(54) **FIDUCIAL MARK PROTECTION IN AN INTEGRATED CIRCUIT PACKAGE**

(30) Priority: 30.10.2024 US 202418932295
(71) Applicant: Avago Technologies International Sales Pte. Limited, Singapore 768923 (SG)
(72) Inventor: Zhao, Sam Ziqun, Irvine, 92618 (US); Tsang, Kwok Cheung, Irvine, 92620 (US); Kim, Hak Nam, Irvine, 92618 (US); Sandhu, Javed Iqbal, San Ramon, 94582 (US); Huang, Wen Hsien, 300 Hsinchu City (TW); Tsau, Liming, Irvine, 92620 (US)
(74) Representative: Dilg, Haeusler, Schindelmann Patentanwaltsgesellschaft mbH

(57) **Abstract**

An example carrier substrate of an integrated circuit (IC) includes: a top surface configured to support a semiconductor die; a bottom surface configured to support solder balls; a plurality of fiducial marks disposed on a surface area comprising at least one of the top surface or the bottom surface, the plurality of fiducial marks comprising metal portions; a first solder resist disposed on the plurality of fiducial marks; and a second solder resist disposed on the surface area other than over the first solder resist, the first solder resist having contrast with respect to the second solder resist.

## Description

### BACKGROUND

Fiducial marks can be markers used in integrated circuit (IC) packaging to assist in alignment and positioning during various stages of the manufacturing and assembly process. On a carrier substrate, for example, fiducial marks can be used on the top surface for alignment during flip-chip die attachment, formation of passive components, and the like. Fiducial marks can be used on the bottom surface of the carrier substrate (e.g., the ball grid array (BGA) side) for alignment during solder ball attachment to package substrate as well as during surface mount of the IC device package onto application system board through reflow soldering process. Fiducial marks can be detected by an optical alignment system during the manufacturing and assembly process to perform alignment in the various stages.

One technique for forming fiducial marks can be to expose a copper pattern under a solder mask on a surface of the carrier substrate (e.g., top surface, bottom surface, or both). The exposed copper can create a pattern of color contrast that is recognizable by the optical alignment system so that the optical alignment system can identify the fiducial marks and their positions. The exposed copper pattern can be coated with a layer of organic solder preservative (OSP) to prevent oxidation and corrosion. The OSP, however, can break down when heated during some stages, such as solder ball reflow, which may then expose the underlying copper pattern to the environment. Exposed copper fiducial marks can become corroded and discolored in the open air, which can cause the optical alignment system to fail to recognize the fiducial marks during alignment. Further, the exposed copper pattern can react with oxygen and water in a humid and hot environment to generate rust and conductive ions, which can become the source of conductive and free-moving ions in a humid and hot environment in addition to discoloring the color pattern of the exposed copper. The unconstrained conductive ions of the exposed copper can cause electrical shorting of exposed terminals, such as passive components on the carrier substrate top surface and solder balls on the bottom surface.

### SUMMARY

In some embodiments, a carrier substrate of an integrated circuit (IC) can include a top surface configured to support a semiconductor die and a bottom surface configured to support solder balls. The carrier substrate can include a plurality of fiducial marks disposed on a surface area comprising at least one of the top surface or the bottom surface. The plurality of fiducial marks can comprise metal portions. The carrier substrate can include a first solder resist disposed on the plurality of fiducial marks. The carrier substrate can include a second solder resist disposed on the surface area other than over the first solder resist. The first solder resist can have contrast with respect to the second solder resist.

In some embodiments, an integrated circuit (IC) can include a carrier substrate having a top surface and a bottom surface, a semiconductor die electrically and mechanically mounted to the top surface of the carrier substrate, and solder balls electrically and mechanically mounted to the bottom surface of the carrier substrate. The IC can include a plurality of fiducial marks disposed on a surface area comprising at least one of the top surface or the bottom surface. The plurality of fiducial marks can comprise metal portions. The IC can include a first solder resist disposed on the plurality of fiducial marks. The IC can include a second solder resist disposed on the surface area other than over the first solder resist. The first solder resist can have contrast with respect to the second solder resist.

In some embodiments, a method of fabricating a carrier substrate for an integrated circuit (IC) is described. The method can include forming the carrier substrate having a top surface configured to support a semiconductor die and a bottom surface configured to support solder balls. The method can include forming a plurality of fiducial marks on a surface area comprising at least one of the tope surface or the bottom surface. The plurality of fiducial marks can comprise metal portions. The method can include depositing a first solder resist on the plurality of fiducial marks. The method can include depositing a second solder resist disposed on the surface area other than over the first solder resist. The first solder resist can have contrast with respect to the second solder resist.

### BRIEF DESCRIPTION OF THE DRAWINGS

Fig. 1 is a side-view of an integrated circuit (IC) according to some embodiments.
Fig. 2A is a top-view of a carrier substrate surface according to some embodiments.
Fig. 2B is a cross-section view of surface taken along the line A-A of Fig. 2A according to some embodiments.
Fig. 3 is a flow diagram depicting a method of fabricating a carrier substrate with fiducial marks according to embodiments.
Fig. 4A is a top-view of a carrier substrate surface according to some embodiments.
Fig. 4B is a cross-section view of surface taken along the line B-B of Fig. 4A according to some embodiments.
Fig. 5 is a flow diagram depicting a method of fabricating a carrier substrate with fiducial marks according to embodiments.
Fig. 6A is a top-view of a carrier substrate surface according to some embodiments.
Fig. 6B is a cross-section view of surface taken along the line C-C of Fig. 6A according to some embodiments.
Fig. 7 is a flow diagram depicting a method of fabricating a carrier substrate with fiducial marks according to embodiments.
Fig. 8 is a flow diagram depicting a method of fabricating a carrier substrate with fiducial marks according to embodiments.

### DETAILED DESCRIPTION

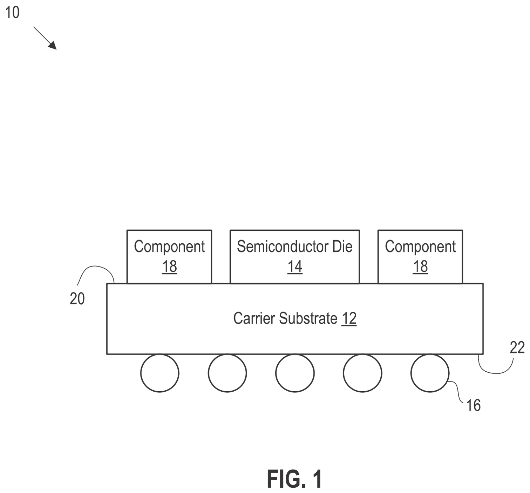

Fig. 1 is a side-view of an integrated circuit (IC) 10 according to some embodiments. IC 10 can include a semiconductor die 14 electrically and mechanically mounted to a carrier substrate 12. Semiconductor die 14 may be a semiconductor material on which a given circuit is fabricated. A carrier substrate may be material that provides a platform to support electronic components, such as one or more semiconductor dice. Carrier substrate 12, in the example, can provide a platform to support semiconductor die 14 along with component(s) 18 (e.g., two components 18 are shown in the example). Each of component(s) 18 can be any type of electronic component, such as a passive component (e.g., a resistor, a capacitor, an inductor, etc.). Carrier substrate 12 can provide mechanical support to its electronic components and IC dice, electrical interconnections, and thermal management. Carrier substrate 12 can include layers of metallization separated by layer(s) of dielectric material (specific layers not shown). Vias can be formed through the dielectric layer(s) to form electrical interconnections between metallization layers. Each metallization layer can be patterned to form traces, pads, etc.

Carrier substrate 12 can include a top surface 20 and a bottom surface 22 opposite top surface 20. Semiconductor die 14 and components 18 can be mechanically and/or electrically connected to conductive patterns of the metallization layer on top surface 20 (e.g., via solder connections). A solder connection may be an electrical and mechanical connection between conductors using solder. Solder may be a low-melting point alloy. Solder balls 16 can be mechanically and/or electrically connected to conductive patterns of the metallization layer on bottom surface 22. A solder ball can be a conductive terminal formed of solder. Metallization layers on carrier substrate 12 can be formed of conductive material, such as copper, aluminum, etc. Dielectric layer(s) on carrier substrate 12 can be formed of a dielectric material. Example dielectric materials include organic materials (e.g., FR-4, BT epoxy, etc.), ceramic materials (e.g., alumina, aluminum nitride, etc.), glass, and the like.

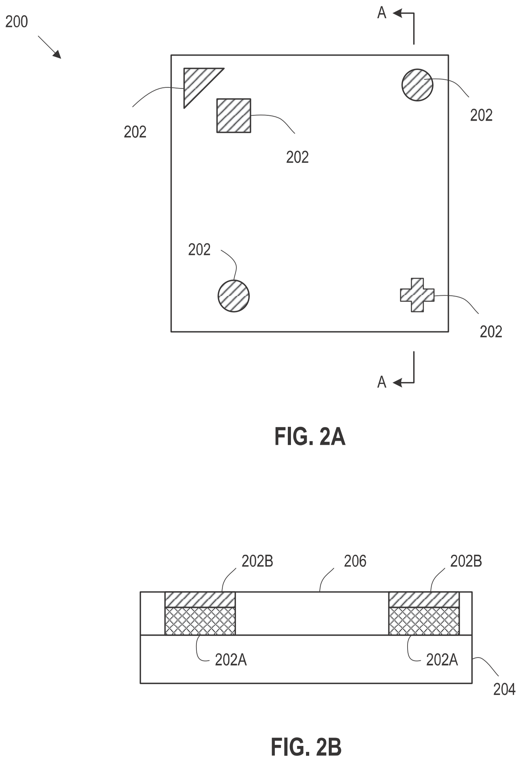

Fig. 2A is a top-view of a carrier substrate surface 200 according to some embodiments. Surface 200 can be top surface 20 or bottom surface 22 of carrier substrate 12 shown in Fig. 1, for example. Surface 200 includes one or more fiducial marks 202. A fiducial mark may be a reference point used in an IC packaging process to assist in alignment and positioning during one or more stages thereof. Fiducial marks can be detected by an optical alignment system during the IC package manufacturing process. For example, an optical alignment system can use fiducial marks 202 when positioning/aligning semiconductor die 14 and components 18 on top surface 20 of carrier substrate 12. In another example, an optical alignment system can use fiducial marks 202 when positioning/aligning solder balls 16 on bottom surface 22 of carrier substrate 12. A fiducial mark 202 can have any shape or size (e.g., square shapes, circular shapes, cross shapes, triangle shapes, etc.). Fiducial marks 202 can have contrast with respect to remaining parts of surface 200 (e.g., dark marks on a light background or light marks on a dark background, where background may be the remaining parts of surface 200 other than fiducial marks 202). The contrast can allow the optical alignment system to detect fiducial marks 202. Contrast may be the difference in light intensity between elements, e.g., between fiducial marks and the surface.

Fig. 2B is a cross-section view of surface 200 taken along the line A-A according to some embodiments. The view shows fiducial marks 202, which can include a metal portion 202A and a dielectric portion 202B. Metal portions 202A can be disposed on a dielectric layer 204 of the carrier substrate. Metal portions 202A can be formed on the metallization layer on top surface 20 or bottom surface 22 of carrier substrate 12. Metal portions 202A can be, for example, copper portions (e.g., copper pads). A dielectric 206 can be formed over dielectric 204 and other portions of the metallization layer on dielectric 204 (not shown). Dielectric 206 can be, for example, a solder resist material. A Dielectric 202B can be formed over metal portions 202A. Dielectric 202B can also be, for example, a solder resist material. In embodiments, dielectric 202B can have contrast with respect to dielectric 206 (e.g., solder masks of different colors, brightness, contrast, etc.). This allows metal portions 202A to remain protected by a solder mask, but also provides contrast or orientation or location identifiers between fiducial marks 202 and the background (e.g., solder mask 206).

Solder resist (also known as solder mask) may be a protective layer deposited over a surface, such as the top and bottom surfaces of carrier substrate 12. Solder resist can be various materials, such as epoxy-based materials, liquid photoimageable materials (e.g., liquid material that can be cured using ultraviolet light), dry film photoimageable materials (e.g., dry material that can be laminated onto a surface and then exposed to ultraviolet light), acrylic materials, thermal-curable materials, and the like. Solder resist 202B and solder resist 206 can be the same material or different materials.

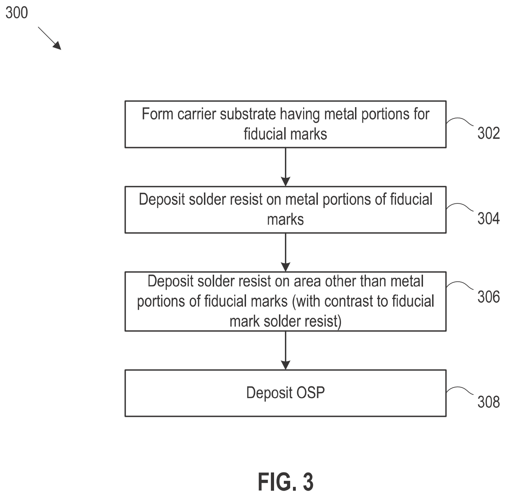

Fig. 3 is a flow diagram depicting a method 300 of fabricating a carrier substrate with fiducial marks according to embodiments. Method 300 can be performed using IC packaging tools, which are well-known in the art. Method 300 begins at step 302, where a carrier substrate can be formed having metal portions for fiducial marks. The fiducial marks can be formed on the top surface, the bottom surface, or both of the carrier substrate. At step 304, solder resist can be deposited on metal portions of the fiducial marks (e.g., copper portions or other metal portions). At step 306, solder resist can be deposited on the area other than the metal portions of the fiducial marks. The solder resist in step 306 can have contrast with respect to the fiducial mark solder resist, as discussed above. At step 308, OSP can be deposited on any exposed metal portions on the surface(s) (e.g., copper pads for die interconnects, component interconnects, solder balls, etc.).

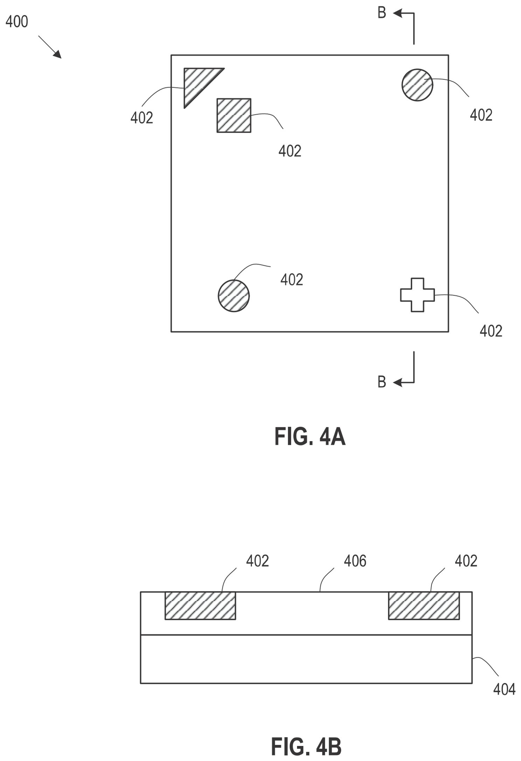

Fig. 4A is a top-view of a carrier substrate surface 400 according to some embodiments. Surface 400 can be top surface 20 or bottom surface 22 of carrier substrate 12 shown in Fig. 1, for example. Surface 400 includes one or more fiducial marks 402. A fiducial mark 402 can have any shape or size (e.g., square shapes, circular shapes, cross shapes, triangle shapes, etc.). Fiducial marks 402 can have contrast with respect to a background of surface 400 (e.g., dark marks on a light background or light marks on a dark background). The contrast can allow the optical alignment system to detect fiducial marks 402 and perform alignment operations.

Fig. 4B is a cross-section view of surface 400 taken along the line B-B according to some embodiments. The view shows fiducial marks 402 being regions of a solder resist 406 deposited on a dielectric 404 of surface 400. The regions are made to be a different contrast with respect to the background area so that fiducial marks 402 can be differentiated from the background. In embodiments, a laser tool can apply a laser to modify solder resist 406 and change its texture in the regions corresponding to fiducial marks 402. The change in texture between the regions of fiducial marks 402 the area other than those regions can provide a change in contrast that can be detected by the optical alignment system.

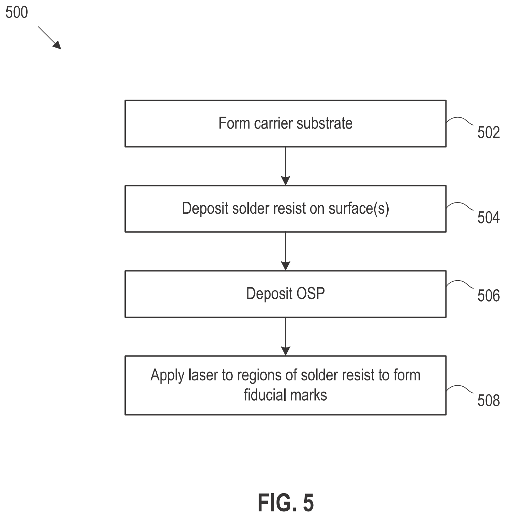

Fig. 5 is a flow diagram depicting a method 500 of fabricating a carrier substrate with fiducial marks according to embodiments. Method 500 can be performed using IC package substrate manufacturing tools, which are well-known in the art. Method 500 begins at step 502, where a carrier substrate can be formed. In the present embodiment, the carrier substrate can be formed without metal portions corresponding to fiducial marks. At step 504, solder resist can be deposited on the surface(s) of the carrier substrate. At step 506, OSP can be deposited on any exposed metal portions on the surface(s) (e.g., copper pads for die interconnects, component interconnects, solder balls, etc.). At step 508, a laser can be applied to regions of the solder resist to form fiducial marks. The lasered portions of the solder resist have contrast with respect to the remaining portion of the solder resist.

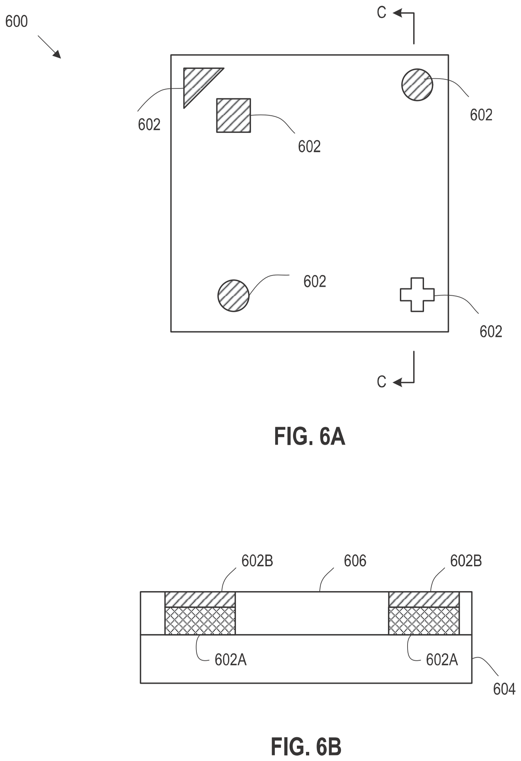

Fig. 6A is a top-view of a carrier substrate surface 600 according to some embodiments. Surface 600 can be top surface 20 or bottom surface 22 of carrier substrate 14 shown in Fig. 1, for example. Surface 600 includes one or more fiducial marks 602. A fiducial mark 602 can have any shape or size (e.g., square shapes, circular shapes, cross shapes, triangle shapes, etc.). Fiducial marks 602 can have contrast with respect to a background of surface 600 (e.g., dark marks on a light background or light marks on a dark background). The contrast can allow the optical alignment system to detect fiducial marks 602.

Fig. 6B is a cross-section view of surface 600 taken along the line C-C according to some embodiments. The view shows fiducial marks 602, which can include a metal portion 602A and conductive portion 602B. Conductive portion 602B can be a different material than metal portion 602A. Metal portions 602A can be disposed on a dielectric layer 604 of the carrier substrate. For example, metal portions 602A can be formed on the metallization layer on top surface 20 or bottom surface 22 of carrier substrate 14. Metal portions 602A can be, for example, copper portions (e.g., copper pads or other metal pads). A dielectric 606 can be formed over dielectric 604 and other portions of the metallization layer on dielectric 204 (not shown). Dielectric 606 can be, for example, a solder resist material. Conductive portion 602B can be solder alloy or immersion tin (ImSn). Immersion tin may be a coating of tin salt deposited on the copper using an electroless chemical process. The electroless chemical process can leave the immersion tin white in color (e.g., immersion tin may also be referred to as white tin). Immersion tin can provide good contrast with respect to the background. In embodiments, conductive portion 602B can have contrast with respect to dielectric 606. This allows metal portions 602A to remain protected by conductive portion 602B, but also provides contrast between fiducial marks 202 and the background (e.g., solder mask 606).

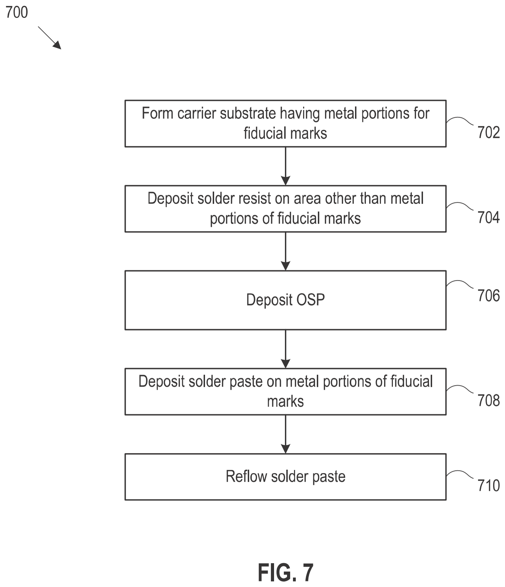

Fig. 7 is a flow diagram depicting a method 700 of fabricating a carrier substrate with fiducial marks according to embodiments. Method 700 can be performed using IC package substrate manufacturing tools, which are well-known in the art. Method 700 begins at step 702, where a carrier substrate can be formed having metal portions for fiducial marks. The fiducial marks can be formed on the top surface, the bottom surface, or both of the carrier substrate. At step 704, solder resist can be deposited on the area other than the metal portions of the fiducial marks. At step 706, OSP can be deposited on any exposed metal portions on the surface(s) (e.g., copper pads for die interconnects, component interconnects, solder balls, fiducial marks, etc.). At step 708, solder paste can be deposited on the metal portions of the fiducial marks. At step 710, solder paste can be reflowed to form the fiducial marks comprising the metal portions and the solder alloy. The solder alloy can protect the metal portions of the fiducial marks and also provide contrast with the background.

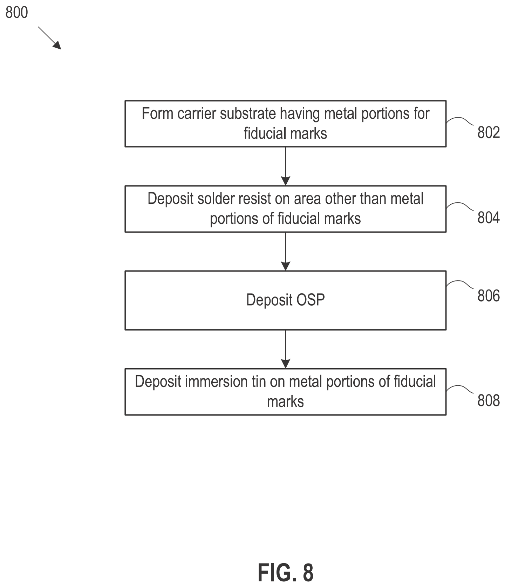

Fig. 8 is a flow diagram depicting a method 800 of fabricating a carrier substrate with fiducial marks according to embodiments. Method 800 can be performed using IC package substrate manufacturing tools, which are well-known in the art. Method 800 begins at step 802, where a carrier substrate can be formed having metal portions for fiducial marks. The fiducial marks can be formed on the top surface, the bottom surface, or both of the carrier substrate. At step 804, solder resist can be deposited on the area other than the metal portions of the fiducial marks. At step 806, OSP can be deposited on any exposed metal portions on the surface(s) (e.g., copper pads for die interconnects, component interconnects, solder balls, etc.). At step 808, immersion tin can be deposited on the metal portions of the fiducial marks to form the fiducial marks comprising the metal portions and the immersion tin. The immersion tin can protect the metal portions of the fiducial marks and also provide contrast with the background.

While some processes and methods having various operations have been described, one or more embodiments also relate to a device or an apparatus for performing these operations. The apparatus may be specially constructed for required purposes, or the apparatus may be a general-purpose computer selectively activated or configured by a computer program stored in the computer. Various general-purpose machines may be used with computer programs written in accordance with the teachings herein, or it may be more convenient to construct a more specialized apparatus to perform the required operations.

Although one or more embodiments of the present invention have been described in some detail for clarity of understanding, certain changes may be made within the scope of the claims. Accordingly, the described embodiments are to be considered as illustrative and not restrictive, and the scope of the claims is not to be limited to details given herein but may be modified within the scope and equivalents of the claims. In the claims, elements and/or steps do not imply any particular order of operation unless explicitly stated in the claims.

Boundaries between components, operations, and data stores are somewhat arbitrary, and particular operations are illustrated in the context of specific illustrative configurations. Other allocations of functionality are envisioned and may fall within the scope of the invention. In general, structures and functionalities presented as separate components in exemplary configurations may be implemented as a combined structure or component. Similarly, structures and functionalities presented as a single component may be implemented as separate components. These and other variations, additions, and improvements may fall within the scope of the appended claims.

## Claims

1. A carrier substrate of an integrated circuit (IC), comprising:
a top surface configured to support a semiconductor die;
a bottom surface configured to support solder balls;
a plurality of fiducial marks disposed on a surface area comprising at least one of the top surface or the bottom surface, the plurality of fiducial marks comprising metal portions;
a first solder resist disposed on the plurality of fiducial marks; and
a second solder resist disposed on the surface area other than over the first solder resist, the first solder resist having contrast with respect to the second solder resist.

2. The carrier substrate of claim 1, wherein
the first solder resist has a different brightness than the second solder resist.

3. The carrier substrate of claim 1 or 2, wherein
the first solder resist is a different color than the second solder resist.

4. The carrier substrate of any one of the claims 1 to 3, wherein
the first solder resist is a first dielectric material different than a second dielectric material of the second solder resist.

5. The carrier substrate of any one of the claims 1 to 3, wherein
the first and second solder resists are the same dielectric material.

6. The carrier substrate of any one of the claims 1 to 4, wherein
the contrast between the first solder resist and the second solder resist is detectable by an optical alignment system.

7. The carrier substrate of any one of the claims 1 to 6, further comprising:
layers of metallization separated by layers of dielectric, the top surface being a top layer of metallization and the bottom surface being a bottom layer of metallization.

8. An integrated circuit (IC), comprising:
a carrier substrate having a top surface and a bottom surface;
a semiconductor die electrically and mechanically mounted to the top surface of the carrier substrate;
solder balls electrically and mechanically mounted to the bottom surface of the carrier substrate;
a plurality of fiducial marks disposed on a surface area comprising at least one of the top surface or the bottom surface, the plurality of fiducial marks comprising metal portions;
a first solder resist disposed on the plurality of fiducial marks; and
a second solder resist disposed on the surface area other than over the first solder resist, the first solder resist having contrast with respect to the second solder resist.

9. The IC of claim 8, wherein
the first solder resist has a different brightness than the second solder resist.

10. The IC of claim 8 or 9, wherein
the first solder resist is a different color than the second solder resist.

11. The IC of any one of the claims 8 to 10, wherein
the first solder resist is a first dielectric material different than a second dielectric material of the second solder resist.

12. The IC of any one of the claims 8 to 10, wherein
the first and second solder resists are the same dielectric material.

13. The IC of any one of the claims 8 to 11, wherein
the contrast between the first solder resist and the second solder resist is detectable by an optical alignment system.

14. The IC of any one of the claims 8 to 13, further comprising:
layers of metallization separated by layers of dielectric, the top surface being a top layer of metallization and the bottom surface being a bottom layer of metallization.

15. A method of fabricating a carrier substrate for an integrated circuit (IC), the method comprising:
forming the carrier substrate having a top surface configured to support a semiconductor die and a bottom surface configured to support solder balls;
forming a plurality of fiducial marks on a surface area comprising at least one of the tope surface or the bottom surface, the plurality of fiducial marks comprising metal portions;
depositing a first solder resist on the plurality of fiducial marks; and
depositing a second solder resist disposed on the surface area other than over the first solder resist, the first solder resist having contrast with respect to the second solder resist.
